# EUROPEAN PATENT APPLICATION

(11) **EP 2 573 096 A1**
(43) Date of publication of application: **27.03.2013**
(21) Application number: 11306193.1
(22) Date of filing: 22.09.2011
(51) Int. Cl.: C07F 9/00, C23C 16/18

(54) **TANTALUM-ORGANIC COMPOUNDS AND THEIR USE FOR THIN FILMS DEPOSITION**

(71) Applicant: L'Air Liquide Société Anonyme pour l'Etude et l'Exploitation des Procédés Georges Claude, 75007 Paris (FR)
(72) Inventor: Correia-Anagleto, Anthony, 94700 Maisons-Alfort (FR); Lahootun, Vanina, 91270 Vigneux sur seine (FR); Zauner, Andreas, 78960 Voisins le Bretonneux (FR)
(74) Representative: Grout de Beaufort, François-Xavier

(57) **Abstract**

Compound of formula (I): 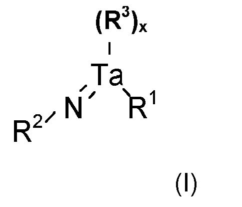 R¹ is a halide ligand (selected from F, Cl, Br or I), an amine or alkyl.
R² is an organic ligand, each one independently selected in the group consisting of H, linear or branched alkyl group comprising from 1 to 6 carbon atoms
R³ is an adduct selected in the group comprising pyridine, arene, THF, CH₃CN and 0 ≤ x ≤4, preferably 1 ≤x ≤ 4.

## Description

The invention concerns new Tantalum-organic compounds and their use for thin films deposition.

With the increasing feature shrinkage in the semiconductor industry, Atomic Layer Deposition (ALD) has proven to be one of the most interesting routes towards good step coverage and uniform thickness conformal films. Numerous tantalum complexes have been described and used for the deposition of tantalum thin films. The latter are either Ta₂O₅ resistive films used as high-k material for insulating layers or TaN conductive films. The most commonly used precursors are TaCl₅, [Ta(N(CH₃)₂)₅] (PDMAT) or [(CH₃)₃CN=Ta(N(Et₂))₃] (TBTDET). However, these complexes present some disadvantages, namely TaCl₅ bearing halide ligands causes the formation of HCl or Cl₂ which is either incorporated in the films as impurities or etches the deposited layers. PDMAT with a tantalum metal in the +V oxidation state is a solid precursor with a limited volatility and produces resistive TaN layers. TBTDET also has a +V metallic centre which does not allow the deposition of TaN conductive thin films even in association with reactive species more reductive than ammonia such as hydrazine.

In view of all the stated problems, a Ta (III) complex [(Ta(Et-C=C-Et)(NMe₂)₃)] was recently disclosed by Dupont de Nemours in order to favour the formation of a conductive TaN film. However, it should be noted that the stated complex has only a poor thermal stability. Indeed, Ta (III) complexes are known to be highly unstable. There are very few Ta (III) mononuclear complexes that have been described in the literature. This is mainly due to the ease with which these complexes form dinuclear or polynuclear species. The mertrichlorotris(pyridine)tantalum (III) TaCl₃.py₃ is one of them. Other known Ta (III) compounds include TaCl₂H(PMe₃)₄, tris(dibenzoylmethanato)Ta or Ta(O₂CNEt₂)₃. In the same way, NbCl₃(py)₃ was synthesized in the early 1980s.

New tantalum metal-organic compounds are required for the vapor phase deposition of tantalum containing thin films.

New precursors are needed for the deposition by vapor phase of pure metal, metal carbide, metal nitride, metal carbo-nitride, metal silicide, metal silico-carbide, metal silico-nitride, metal oxides or metal silico-oxide.

Those films are highly desirable for application in the semiconductor industry either as:
● Copper diffusion barrier in BEOL applications
● CMOS metal gate
● High-k layers in memory devices
● Metal electrodes for Metal-Insulator-Metal applications (DRAM, etc...).

Despite the fact that the precursors are suitable for applications in the semiconductor industry, their use is not limited to this industry only. Tantalum containing layers can be used, among other applications, to increase wear resistance, for catalytic applications, or as sensors.

The present invention concerns compounds of formula (I): 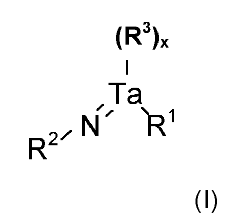
R¹ is a halide ligand (selected from F, Cl, Br or I), an amine or alkyl.
R² is an organic ligand, each one independently selected in the group consisting of H, linear or branched alkyl group comprising from 1 to 6 carbon atoms
R³ is an adduct selected in the group comprising pyridine, arene, THF, CH₃CN and 0 ≤ x ≤ 4, preferably 1 ≤ x ≤ 4.

Acoording to an embodiment, yhe invention concerns the compounds:
TaCl(NMe)(η⁶⁻C₆(CH₃)₆)
TaMe(NMe).(η⁶⁻C₆(CH₃)₆)
Ta(NMe)(OMe). Py
Ta(NtBu)(OEt).Py
Ta(NiPr)(O*t*Bu).Py
TaCl(NMe).(THF)₃
Ta(NMe)(OMe).(THF)₃.

This novel family of metal-organic compounds has attractive thermal properties. The proposed new metal-organic precursors present the advantages of:
● being thermally stable to enable proper distribution (gas phase or direct liquid injection) without particles generation,
● being possible to be dissolved in organic solvants,
● allowing the deposition of a variety of Ta containing films, including without limitation binary, ternary and more materials, by using one or a combination of co-reactants.

According to other embodiments, the present invention concerns new tantalum-organic precursors having the general formula of TaNR¹R².(R³)ₓ whereby:
- R¹ = halide, R² = alkyl,
- R¹ = R² = alkyl,
- R¹ = O-alkyl, R² = alkyl,
- R¹ = O-aryl, R² = alkyl,
- R¹ = R² = PCAI-R (represented below, where R = alkyl, aryl) PCAI-R = 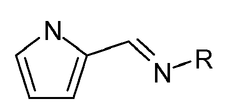
- R¹ = PCAI-R (represented below, where R = alkyl, aryl), R² = O-alkyl,
- R¹ = PCAI-R (represented below, where R = alkyl, aryl), R² = O-aryl,
- R¹ = PCAI-R (represented below, where R = alkyl, aryl), R² = amine;
and R³ is an adduct selected in the group comprising pyridine, arene, acetonitrile or THF and x ≤ 4.

According to another embodiment, the invention concerns a method of forming a tantalum-containing layer on a substrate surface, the method comprising at least the steps of:
a) providing a vapor comprising at least one precursor compound of the formula (I) as defined above;
b) reacting the vapor comprising the at least one compound of formula (I) with the substrate, according to a method selected from (MO)CVD (Metal-Organic Chemical Vapor Deposition), ALD (Atomic Layer Deposition), PEALD (Plasma Enhanced Atomic Layer Deposition), PECVD (Plasma Enhanced Chemical Vapor Deposition) and derivative vapor phase deposition methods, to form a layer of a at least tantalum-containing complex on at least one surface of said substrate.

According to another embodiment, the invention concerns a method as defined above further comprising the step:
c) reaction of the complex obtained in step b) with at least one reactant selected from another metal source, reducing reactants and/or nitriding reactants and/or oxidizing reactants.

According to another embodiment, the invention concerns a method as defined above, wherein the at least one reactant is selected in the group consisting of, oxygen (O₂), oxygen radicals (for instance O· or OH·), for instance generated by a remote plasma, ozone (O₃), moisture (H₂O) and H₂O₂.

According to another embodiment, the invention concerns a method as defined above, wherein the at least one reactant is selected in the group consisting of SiH₄, Si₂H₆, Si₃H₈, SAM 24 (SiH₂(NEt₂)₂ Bis(diethylamino)silane), TriDMAS (SiH(NMe₂)₃), BDMAS (SiH₂(NMe₂)₂), BDEAS (SiH₂(NEt₂)₂), TDEAS (SiH(NEt₂)₃), TDMAS (SiH(NMe₂)₃), 3MS (trimethylsilane), 4MS (tetramethylsilane), TEMAS (SiH(NEtMe)₃), (SiH₃)₃N, (SiH₃)₂O, trisilylamine, disiloxane, trisilylamine, a alkoxysilane SiHₓ(OR¹)₄₋ₓ (where x is comprised between 0 and 3), a silanol Si(OH)ₓ(OR¹)₄₋ₓ (preferably Si(OH)(OR¹)₃; more preferably Si(OH)(OtBu)₃ an aminosilane SiHₓ(NR¹R²)₄₋ₓ (where x is comprised between 0 and 3); R¹ and R² are independently from H or a C1-C6 carbon chain, either linear, branched or cyclic; preferably TriDMAS SiH(NMe₂)₃, BTBAS SiH₂(NHtBu)₂; BDEAS SiH₂(NEt₂)₂ and mixtures thereof.

According to another embodiment, the invention concerns a method as defined above, wherein the reactants can be introduced simultaneously (chemical vapor deposition), sequentially (atomic layer deposition) or different combinations such as introducing tantalum source and the other precursor source together in one pulse and oxygen in a separate pulse (modified atomic layer deposition); or introducing oxygen continuously and to introduce metal source by pulse (pulsed-chemical vapor deposition).

According to another embodiment, the invention concerns a method as defined above, wherein said another metal source is selected from any other element in the group II, III-A, III-B, transition metal, lanthanoids, or rare-earth metals.

According to another embodiment, the invention concerns a method as defined above, wherein the temperature of the substrate is comprised between 300°C and 450°C.

According to another embodiment, the invention concerns a method as defined above, wherein the substrate is selected in the group consisting of Si, SiOₓ, SiNₓ, SiOₓN_{y}, Cu, GeOₓ.

According to another embodiment, the invention concerns a substrate coated with one or more film monolayers of one or more metals, obtained by a method selected from (MO)CVD (Metal-Organic Chemical Vapor Deposition), ALD (Atomic Layer Deposition), PEALD (Plasma Enhanced Atomic Layer Deposition), PECVD (Plasma Enhanced Chemical Vapor Deposition) and derivative vapor phase deposition methods, wherein at least one precursor is a metal source precursor as defined above.

According to another embodiment, the invention concerns a method of manufacturing a semiconductor device product comprising contacting a semiconductor device substrate with a tantalum source precursor as defined above, to deposit tantalum on the substrate.

According to another embodiment, the invention concerns a method of manufacturing a photovoltaic device product comprising contacting a photovoltaic device substrate with a tantalum source precursor as defined above, to deposit tantalum on the substrate.

The new metal-organic precursors of the invention are preferably liquids at room temperature or with a melting point lower than 100°C, or easily to liquefy for easy handling.

These new metal organic precursors exhibit a vapour pressure equal or higher than 1 mbar at 100°C.

The new metal-organic precursors are solid at room temperature and can be vaporized using a sublimator.

### Method of depositing Tantalum-containing films: Ta, TaC, TaCN, Ta₂O₅, TaOₓN_{y} TaM²OₓN_{y}.

The deposition of Tantalum based materials as thin films, using TaNR¹R².(R³)ₓ(I) as metal source above described, includes the steps of:
● The formation of a gas phase metal source by vaporizing the said tantalum source.
● Feeding a plurality of precursors in vapor phase to a reaction chamber, wherein said precursors comprise said vaporized metal source, and may comprise without limitation another metal source, an oxygen source, a nitrogen source, a carbon source; and forming the said metal containing thin film.

In one embodiment of the invention, the vaporization of the new metal-organic compound is realized by introducing a carrier gas into a heated bubbler containing the said new metal source.
● The carrier gas can be selected from Ar, He, H₂, N₂, or mixtures of them.
● The container is preferably heated at a temperature at which the said metal source is in liquid phase and at a sufficient vapor pressure. Typically, heating temperatures can range from 15°C to 300 °C. The temperature of the container can be adjusted to control the amount of injected metal source gas phase.
● The said metal source can be mixed in the container to a solvent or a mixture of solvent, to another metal source, or to a mixture of them.

In another embodiment of the invention, the said metal source is fed in its liquid phase to a vaporizer where it is vaporized.
● The said metal source can be mixed to another metal source in its liquid phase.
● The said mixture of metal sources can be mixed to a solvent or a mixture of solvent.
● The said solvent can be selected in the group consisting of alcanes such as hexane, heptane, octane, aromatic solvents such as benzene, toluene, mesitylene, xylene, silicon containing solvent such as hexamethyldisiloxane, hexamethyldisilazane, tetramethylsilane, sulphur containing solvents such as dimethylsulfoxide or oxygen containing solvent such as tetrahydrofuran, dioxane.
● The said metal source can be mixed to a stabilizer.

In another embodiment of the invention, the said metal source is fed in its solid phase to a sublimator where it is vaporized.

The said vaporized metal source is introduced into a reaction chamber where it is contacted to a substrate. The substrate can be selected in the group consisting of Si, SiOₓ, SiNₓ, SiOₓN_{y}, Cu, GeOₓ. The substrate can be heated to sufficient temperature to obtain the material at sufficient growth rate and with desired physical properties and composition.
● Typical deposition temperatures range from 150°C to 600°C,
● Preferably the temperature is lower or equal to 450°C.
● The pressure in the reaction chamber is controlled to obtain the desired metal containing film at sufficient growth rate. The typical pressure range is from 1.33 mBar to 133 mBar or higher.

The said metal source and the reactant species can be introduced:
● Simultaneously (Metal Organic Chemical Vapor Deposition) with or without the assistance of a plasma source;
● Sequentially (Atomic Layer Deposition) with or without the assistance of a plasma source or different combinations :
   o one example is to introduce metal source and the other metal source together in one pulse and reactant species in a separate pulse (modified Atomic Layer Deposition);
   o another example is to introduce the reactant species (one example could be oxygen) continuously and to introduce metal source by pulses (pulsed Chemical Vapor Deposition).

In one embodiment of the invention, the said metal source is introduced in the reaction chamber without reactant species.

In one embodiment of the invention, the said metal source is mixed to reactant species prior to the reaction chamber.

In another embodiment of the invention, the said metal source and the reactant species are introduced simultaneously in the reaction chamber.

In another embodiment of the invention, the said metal source and the reactant species are introduced sequentially in the reaction chamber.

In one embodiment of the invention, the reactant species are passed through a remote plasma system and decomposed to radicals.

In one embodiment of the invention where the targeted metal based film contains oxygen, such as metal oxide or metal oxy-nitride, the said reactant species include an oxygen source which is selected from, but not limited to, oxygen (O₂), oxygen radicals (for instance O· or OH·), for instance generated by a remote plasma system, ozone (O₃), NO, N₂O, NO₂, moisture (H₂O) or H₂O₂.

In one embodiment of the invention where the targeted metal based film contains nitrogen, such as, metal nitride or metal carbo-nitride, the said reactant species include a nitrogen source which is selected from, but not limited to, nitrogen (N₂), ammonia, hydrazine and alkyl derivatives, N-containing radicals (for instance N·, NH·, NH₂·), NO, N₂O, NO₂ or amines.

In one embodiment of the invention where the targeted metal based film contains carbon, such as metal carbide or metal carbo-nitride, the said reactant species include a carbon source which is selected from, but not limited to, methane, ethane, propane, butane, isobutane, ethylene, propylene, isobutylene or CCl₄.

In one embodiment of the invention where the targeted metal based film contains silicon, such as metal silicide, silico-nitride, silicate, silico-carbo-nitride, the said reactant species include a silicon source which is selected from, but not limited to, SiH₄, Si₂H₆, Si₃H₈, SAM 24 (SiH₂(NEt₂)₂ Bis(diethylamino)silane), TriDMAS (SiH(NMe₂)₃), BDMAS (SiH₂(NMe₂)₂), BDEAS (SiH₂(NEt₂)₂), TDEAS (SiH(NEt₂)₃), TDMAS (SiH(NMe₂)₃), 3MS (trimethylsilane), 4MS (tetramethylsilane), TEMAS (SiH(NEtMe)₃), (SiH₃)₃N, (SiH₃)₂O, trisilylamine, disiloxane, trisilylamine, a alkoxysilane SiHₓ(OR¹)₄₋ₓ (where x is comprised between 0 and 3), a silanol Si(OH)(OR¹)₄₋ₓ (preferably Si(OH)(OR¹)₃ ; more preferably Si(OH)(OtBu)₃ an aminosilane SiHₓ(NR¹R²)₄₋ₓ (where x is comprised between 0 and 3); R¹ and R² are independently from H or a C1-C6 carbon chain, either linear, branched or cyclic; preferably TriDMAS SiH(NMe₂)₃, BTBAS SiH₂(NHtBu)₂; BDEAS SiH₂(NEt₂)₂ and mixtures thereof. The targeted film can alternatively contain Germanium. The above-mentioned Si containing sources could be replaced by Ge containing sources.

In one embodiment of the invention, the said metal source is mixed to another metal source to deposit a multi-metal containing film.
● The said metal sources can be simultaneously introduced and mixed into the reaction chamber.
● The said metal sources are simultaneously introduced and mixed to reactant species into the reaction chamber.
● The said metal-organic compounds are used to deposit metal-containing thin films by Atomic Layer Deposition. The said metal source, a possible second metal source, and the reactant species are introduced sequentially in the reaction chamber (Atomic Layer Deposition). The reactor pressure is selected in the range from 1 to 133 mBar or higher. Preferably, the reactor pressure is comprised between 1 and 13 mBar. A purge gas (or vacuum step) is introduced between the metal source pulse and the reactant species pulse. The purge gas (or vacuum step) can be selected without limitation from the group consisting of N₂, Ar, He or H₂. The metal source, purge gas and reactant species pulse duration is independently comprised between 0,1 and 100 s. Preferably, the pulse duration is comprised between 0,5 and 10 s.
● The second metal source is selected independently and without limitation selected from any other element in the group II, III-A, III-B, transition metal, lanthanoids, or rare-earth metals.

### Examples:

**A. CVD process using TaMe(NMe).(η⁶⁻C₆(CH₃)₆) and ammonia**
   TaMe(NMe).(n⁶⁻C₆(CH₃)₆) is stored into a container. The container is heated at 120°C and N₂ is used as carrier gas at a flow of 50 sccm. Ammonia (NH₃) is used as nitrogen source. The substrate is heated at 400°C. The precursor is simultaneously introduced into the reaction chamber with NH₃. A tantalum nitride film is obtained.
**B. CVD process using TaMe(NMe).(η⁶⁻C₆(CH₃)₆) and ozone**
   TaMe(NMe).(η⁶⁻C₆(CH₃)₆) is stored into a container. The container is heated at 120°C and N₂ is used as carrier gas at a flow of 50 sccm. Ozone (O₃) is used as oxygen source. The substrate is heated at 400°C. The precursor is simultaneously introduced into the reaction chamber with O₃. A tantalum oxyde film is obtained.
**C. ALD process using TaMe(NMe).(η⁶⁻C₆(CH₃)₆) and ammonia**
   TaMe(NMe).(n⁶⁻C₆(CH₃)₆) is stored into a container. The container is heated at 120°C and N₂ is used as carrier gas at a flow of 50sccm. Ammonia (NH₃) is used as nitrogen source. The substrate is heated at 300°C. The precursor is sequentially introduced into the reaction chamber with NH₃ during the first step a pulse of TaMe(NMe).(η⁶⁻C₆(CH₃)₆) is introduced during 8 seconds, followed by a 13 seconds N₂ purge. A pulse of NH₃ is then introduced into the reaction chamber during 8 seconds, followed by a 13 seconds N₂ purge. The first step is then done again. 400 cycles are performed this way. A tantalum nitride film is obtained.
**D. ALD process using TaMe(NMe).(η⁶⁻C₆(CH₃)₆) and ozone**
   TaMe(NMe).(η⁶⁻C₆(CH₃)₆) is stored into a container. The container is heated at 120°C and N₂ is used as carrier gas at a flow of 50sccm. Ozone (O₃) is used as oxygen source. The substrate is heated at 300°C. The precursor is sequentially introduced into the reaction chamber with O₃ during the first step a pulse of TaMe(NMe).(η⁶⁻C₆(CH₃)₆) is introduced during 8 seconds, followed by a 13 seconds N₂ purge. A pulse of O₃ is then introduced into the reaction chamber during 8 seconds, followed by a 13 seconds N₂ purge. The first step is then done again. 400 cycles are performed this way. A tantalum oxyde film is obtained.

## Claims

1. Compound of formula (I): 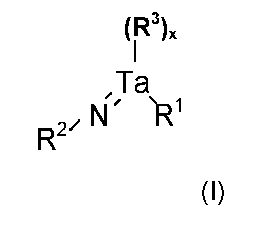
R¹ is a halide ligand (selected from F, Cl, Br or I), an amine or alkyl.
R² is an organic ligand, each one independently selected in the group consisting of H, linear or branched alkyl group comprising from 1 to 6 carbon atoms
R³ is an adduct selected in the group comprising pyridine, arene, THF, CH₃CN and 0 ≤ x ≤ 4, preferably 1 ≤ x ≤ 4.

2. The compounds:
TaCl(NMe)(η⁶⁻C₆(CH₃)₆)
TaMe(NMe).(η⁶⁻C₆(CH₃)₆)
Ta(NMe)(OMe).Py
Ta(NtBu)(OEt).Py
Ta(NiPr)(O*t*Bu).Py
TaCl(NMe).(THF)₃
Ta(NMe)(OMe).(THF)₃.

3. Method of forming a tantalum-containing layer on a substrate surface, the method comprising at least the steps of:
a) providing a vapor comprising at least one precursor compound (I) as defined in claim 1 or claim 2;
b) reacting the vapor comprising the at least one compound (I) with the substrate, according to a method selected from (MO)CVD (Metal-Organic Chemical Vapor Deposition), ALD (Atomic Layer Deposition), PEALD (Plasma Enhanced Atomic Layer Deposition), PECVD (Plasma Enhanced Chemical Vapor Deposition) and derivative vapor phase deposition methods, to form a layer of a at least Tantalum-containing complex on at least one surface of said substrate.

4. Method of claim 3 further comprising the step:
c) reaction of the complex formed obtained in step b) with at least one reactant selected from another metal source, reducing reactants and/or nitriding reactants and/or oxidizing reactants.

5. Method of claim 4, wherein the at least one reactant is selected in the group consisting of, oxygen (O₂), oxygen radicals (for instance O· or OH·), for instance generated by a remote plasma, ozone (O₃), moisture (H₂O) and H₂O₂.

6. Method of claim 4, wherein the at least one reactant is selected in the group consisting of SiH₄, Si₂H₆, Si₃H₈, SAM 24 (SiH₂(NEt₂)₂ Bis(diethylamino)silane), TriDMAS (SiH(NMe₂)₃), BDMAS (SiH₂(NMe₂)₂), BDEAS (SiH₂(NEt₂)₂), TDEAS (SiH(NEt₂)₃), TDMAS (SiH(NMe₂)₃), 3MS (trimethylsilane), 4MS (tetramethylsilane), TEMAS (SiH(NEtMe)₃), (SiH₃)₃N, (SiH₃)₂O, trisilylamine, disiloxane, trisilylamine, a alkoxysilane SiHₓ(OR¹)₄₋ₓ (where x is comprised between 0 and 3), a silanol Si(OH)ₓ(OR¹)₄₋ₓ (preferably Si(OH)(OR¹)₃ ; more preferably Si(OH)(OtBu)₃ an aminosilane SiHₓ(NR¹R²)₄₋ₓ (where x is comprised between 0 and 3); R¹ and R² are independently from H or a C1-C6 carbon chain, either linear, branched or cyclic; preferably TriDMAS SiH(NMe₂)₃, BTBAS SiH₂(NHtBu)₂; BDEAS SiH₂(NEt₂)₂ and mixtures thereof.

7. Method of one of claims 4 to 6, wherein the reactants can be introduced simultaneously (chemical vapor deposition), sequentially (atomic layer deposition) or different combinations such as introducing tantalum source (I) and the other precursor source together in one pulse and oxygen in a separate pulse (modified atomic layer deposition); or introducing oxygen continuously and to introduce metal source by pulse (pulsed-chemical vapor deposition).

8. Method of one of claims 4 to 7, wherein said another metal source is selected from any other element in the group II, III-A, III-B, transition metal, lanthanoids, or rare-earth metals.

9. Method of one of claims 3 to 8, wherein the temperature of the substrate is comprised between 300°C and 450°C.

10. Method of one of claims 3 to 9, wherein the substrate is selected in the group consisting of Si, SiOₓ, SiNₓ, SiOₓN_{y}, Cu, GeOₓ.

11. A substrate coated with one or more film monolayers of one or more metals, obtained by a method selected from (MO)CVD (Metal-Organic Chemical Vapor Deposition), ALD (Atomic Layer Deposition), PEALD (Plasma Enhanced Atomic Layer Deposition), PECVD (Plasma Enhanced Chemical Vapor Deposition) and derivative vapor phase deposition methods, wherein at least one precursor is a metal source precursor as defined in claim 1 or 2.

12. Method of manufacturing a semiconductor device product comprising contacting a semiconductor device substrate with a tantalum source precursor as defined in claim 1 or 2, to deposit tantalum on the substrate.

13. Method of manufacturing a photovoltaic device product comprising contacting a photovoltaic device substrate with a tantalum source precursor as defined in claim 1 or 2, to deposit tantalum on the substrate.
